# EUROPÄISCHE PATENTSCHRIFT

(11) **EP 2 821 296 B1**
(45) Veröffentlichungstag und Bekanntmachung des Hinweises auf die Patenterteilung: **15.03.2017**
(21) Anmeldenummer: 14172721.4
(22) Anmeldetag: 17.06.2014
(51) Int. Cl.: B60R 25/20, B60R 25/24, E05B 81/78

(54) **ERFASSUNGSVERFAHREN FÜR BETÄTIGUNGSGESTEN**
DETECTION METHOD FOR ACTUATION GESTURES
PROCÉDÉ DE DÉTECTION DE GESTES D'ACTIONNEMENT

(30) Priorität: 03.07.2013 DE 102013106968; 23.09.2013 DE 102013110506
(43) Veröffentlichungstag der Anmeldung: 07.01.2015
(73) Patentinhaber: Huf Hülsbeck & Fürst GmbH & Co. KG, 42551 Velbert (DE)
(72) Erfinder: Schindler, Mirko, 42549 Velbert (DE); Van Gastel, Peter, 42699 Solingen (DE); Gerdes, Bernd, 45355 Essen (DE)
(74) Vertreter: Zenz Patentanwälte Partnerschaft mbB

(56) Entgegenhaltungen:
- WO-A1-2012/034768
- WO-A1-2012/055518
- DE-A1-102008 063 366
- DE-A1-102009 017 404
- DE-A1-102010 018 164
- DE-A1-102011 051 434
- DE-B3-102004 041 709
- FR-A1- 2 979 873
- US-B2- 8 091 280

## Beschreibung

Die Erfindung betrifft ein Erfassungsverfahren zur Erfassung von Betätigungsgesten an einem Kraftfahrzeug. Insbesondere betrifft die Erfindung ein Verfahren, um von einem Benutzer zum Zugriff auf eine Fahrzeugfunktion ausgeübte Betätigungsgesten zu detektieren.

Einrichtungen zur berührungslosen Betätigung von Kraftfahrzeugfunktionen sind aus dem Stand der Technik bekannt. Beispielsweise beschreibt die DE 10 2008 063 366 eine berührungslos betätigbare Heckklappe. Diese Einrichtung erlaubt es einem Benutzer, eine Betätigungsgeste im Fußbereich unter dem Heckstoßfänger auszuführen, um die Heckklappe zu öffnen. Dafür sind bei dieser Einrichtung Kapazitätssensoren vorgesehen, die mit ihrem Erfassungsbereich zur Erfassung unterschiedlicher Raumbereiche ausgerichtet sind, und anhand deren Signale eine Betätigungsgeste erfasst wird.

Eine solche berührungslose Betätigung einer Heckklappe ist dem Komfort und der Sicherheit zuträglich, wenn einer Person aus irgendwelchen Gründen die händische Betätigung einer Heckklappe nur erschwert möglich ist.

Die Erfassung einer Bewegung kann eine Körperbewegung, zum Beispiel das Ausführen einer angetäuschten Kick-Bewegung, das Anheben und Schwenken des Beines oder ähnliches erfassen. Es ist jedoch zu vermeiden, dass auch Betätigungen dann erkannt und eine Funktion ausgelöst wird, wenn gar nicht gezielt eine entsprechende Betätigungsgeste ausgeführt wurde. Dies kann beispielsweise durch in den Erfassungsbereich gelangende Objekte (Bälle, Haustiere oder ähnliches) geschehen.

Aus der DE 10 2004 041 709 ist eine Einrichtung zur berührungslosen Betätigung einer Heckklappe bekannt, wobei vorgeschlagen wird, zwei Sensoranordnungen mit getrennten Detektionsbereichen zu verwenden. Hierzu kann beispielsweise ein Ultraschall-Abstandserfassungssystem als eine der Sensoreinrichtungen ein verwendet werden, welches ohnehin am Kraftfahrzeug für Abstandsmessungen vorgesehen ist.

Das Dokument DE 10 2009 017 404 A1 beschreibt ein Verfahren und eine Vorrichtung zur Heckklappenbetätigung. Es wird eine kapazitive Sensorelektrode verwendet, die eine Schwenk- oder Trittbewegung eines Fußes als Öffnungsgeste erfasst.

Die DE 10 2011 051 434 A1 offenbart ebenfalls eine Sensorik zur Erfassung einer Öffnungsgeste im Heckbereich eines Fahrzeugs. Die Einrichtung ist zur Reduzierung des Energiebedarfs eingerichtet, mit veränderlichen Taktraten betrieben zu werden.

Die US 8091280 offenbart eine handfreie Betätigungseinrichtung, wobei eine optische Erfassung eines Fußes in einem optisch markierten Bereich vorgenommen wird.

Die vorhandenen Erfassungssysteme sind jedoch hinsichtlich der Betätigung in verschiedenen Bereichen unvorteilhaft. Wenn es einem Benutzer aufgrund von körperlichen Einschränkungen oder auch Vorgaben der Verhaltensweisen nicht möglich ist, eine entsprechende Bewegung auszuführen, sind diese Betätigungssysteme aufgrund der geforderten Dynamik der Bewegung nicht geeignet.

Aufgabe der Erfindung ist es, ein Auswerteverfahren für berührungslos betätigte Sensoranordnungen zur Verfügung zu stellen, welches die Erkennungsgenauigkeit erhöht und Einschränkungen der Bewegungsmöglichkeiten eines Benutzers berücksichtigt.

Gelöst wird diese Aufgabe durch ein Verfahren mit den Merkmalen des Patentanspruchs 1.

Das Verfahren zur Betätigungsabfrage für eine Funktion an einem Kraftfahrzeug hat eine Sensoranordnung, wobei die Sensoranordnung wenigstens zwei beabstandete Sensoreinrichtungen zur Erfassung von jeweiligen Bedienungen durch Annäherungen eines Körperteils eines Benutzers aufweist. Die Sensoreinrichtungen weisen jeweils einen Erfassungsbereich auf. Dies ist ein Raumbereich, in dem eine Annäherung oder Anwesenheit eines Körperteils eines Benutzers durch die zugehörige Sensoreinrichtung detektierbar ist.

Die Detektion an sich kann durch die bekannten Arten von Annäherungssensoren vorgenommen werden, z.B. optische Sensoren, Ultraschallsensoren oder kapazitive Sensoren.

Die Sensoreinrichtungen sind an dem Fahrzeug versetzt angeordnet und die Erfassungsbereiche decken unterschiedliche Raumbereiche ab, wobei eine teilweise Überlappung möglich ist.

Gemäß der Erfindung wird der Erfassung einer Betätigung in ihrer Dynamik verlangsamt. Dazu wird vorgesehen, dass die Betätigung erkannt wird, wenn ein Benutzer in einem vorgegebenen Zeitschema ein bestimmtes Verhalten nachvollzieht. Insbesondere ist dazu das ruhende Verweilen eines Bedienkörperteils in einem Erfassungsbereich erforderlich und die Entfernung des Bedienkörperteils aus dem Erfassungsbereich nach Signalisierung durch das Fahrzeug. Hierzu werden die zwei Sensoreinrichtungen genutzt. Eine der Sensoreinrichtungen, in dieser Beschreibung als erste Sensoreinrichtung bezeichnet, ist mit ihrem Erfassungsbereich so ausgerichtet, dass der Erfassungsbereich dem durch Benutzer und deren Körperteile häufig frequentierten Raumbereichen abgewandt ist. Beispielsweise kann der Erfassungsbereich sich unterhalb des Fahrzeuges befinden. Die zweite Sensoreinrichtung überwacht einen Bereich, in dem sich ein Bediener zwangsläufig aufhalten muss, wenn er eine Bedienung im Bereich der ersten Sensoreinrichtung vornehmen will. Durch die doppelte Erfassung wird ausgeschlossen, dass eine Anwesenheit von Körpern oder Objekten im Erfassungsbereich der ersten Sensoranordnung als Bediener erkannt wird, wenn es sich nur um Fehlerkennungen handelt (z.B. Bälle oder Tiere, die sich unterhalb eines parkenden Fahrzeuges befinden).

Zum Erfassen der Betätigung werden die Signale der ersten Sensoreinrichtung von den Sensoreinrichtungen überwacht, bis eine charakteristische erste Signalantwort s1 von der ersten Sensoreinrichtung erfasst wird, die eine Bedienung durch Annäherung an die erste Sensoreinrichtung anzeigt. Was eine charakteristische Signalantwort ist, ist je nach verwendeten Sensoren dem Stand der Technik zu entnehmen. Bei kapazitiven Sensoren handelt es sich um eine signifikante Änderung der Kapazität einer Elektrodenanordnung (siehe z.B. WO 2012/034768).

Außerdem erfolgt eine Abfrage eines von einem Benutzer mitführbarer ID-Gebers, um eine Autorisierung für den Zugriff auf die angeforderte Funktion zu verifizieren. Derartige ID-Geber sind aus dem Bereich der Keyless-Go Systeme bekannt und kommunizieren mit dem Steuersystem des Fahrzeuges im drahtlos im Hochfrequenzbereich (HF), wobei ein Wecken des ID-Gebers auch im Niederfrequenzbereich erfolgen kann. Diese Kommunikation mit dem ID-Geber stellt sicher, dass eine Betätigung nur von einer Autorisierten Person vorgenommen werden kann, die sich in einem vorgegebenen Bereich um das Fahrzeug aufhält. Dafür ist die Abfrage durch Antennenanordnung und Ansteuerung der Antennen regelmäßig auf einen bestimmten Fahrzeugbereich beschränkt, z.B. auf den Heckbereich, sofern die Betätigung eine Heckklappe betrifft.

Die Abfrage des ID-Gebers kann davon abhängig gemacht werden, ob die erste Sensoreinrichtung eine Annäherung oder Anwesenheit eines Körpers erkannt hat. Dann ist die ID-Geber Abfrage der Sensorerfassung nachgeordnet. Diese Abhängigkeit ist jedoch nicht erforderlich, es kann auch eine Abfrage des ID-Gebers vor der Sensorabfrage erfolgen, z.B. durch ein wiederholtes Aussenden von Weckrufen an den ID-Geber vom Fahrzeug aus (pollendes System). In diesem Fall liegt dann die Autorisierung bereits vor, wenn die Annäherung durch den ersten Sensor erfasst wird.

Um zu überprüfen, ob die Anwesenheits- oder Annäherungsdetektion der ersten Sensoreinrichtung tatsächlich durch einen Benutzer hervorgerufen wurde, werden die Signale einer zweiten Sensoreinrichtung erfasst. Die zweite Sensoreinrichtung weist einen Erfassungsbereich auf, der versetzt zu demjenigen der ersten Sensoreinrichtung ist. Dabei gilt, dass sich der Körper einer bedienenden Person in dem Erfassungsbereich der zweiten Sensoreinrichtung befinden muss, wenn eine valide Betätigung der ersten Sensoreinrichtung detektiert werden soll. Beispielsweise kann der Erfassungsbereich der zweiten Sensoreinrichtung in einem Bereich seitlich vom Fahrzeug gerichtet sein, dort wo eine Person steht, die ein Körperteil in den Erfassungsbereich der ersten Sensoreinrichtung bringt.

Zur erfolgreichen Betätigung muss also sowohl eine Annäherung im Bereich der ersten Sensorerfassung als auch im Bereich der zweiten Sensoreinrichtung detektierbar sein.

Sind diese Bedingungen erfüllt, liefern also die erste Sensoreinrichtung und die zweite Sensoreinrichtung beide charakteristische Signale für eine Anwesenheit des Bedienerkörperteils, wird fahrzeugseitig eine vorgegebene Zeitdauer t1 überwacht. Während dieser Zeitdauer müssen sowohl die Sensorsignale der ersten Sensoreinrichtung als auch die der zweiten Sensoreinrichtung weiterhin einen Aufenthalt des Bedienkörperteils bzw. Bedieners im Erfassungsbereich anzeigen. Dazu werden die beiden Sensoreinrichtungen während der Zeitdauer t1 wiederholt oder kontinuierlich abgefragt, zumindest aber findet eine erneute Abfrage zum Ablauf der Zeitdauer t1 statt.

Zeigen diese Überprüfungen der Signale während der Zeitdauer und zum Ende der Zeitdauer eine fortgesetzte Bedienung, also einen Aufenthalt des Bedienkörperteils in den Erfassungsbereichen an, wird der Ablauf der Zeitdauer t1 an den Benutzer signalisiert. Grundsätzlich kann auch der Start der Zeitdauer t1 an dem Benutzer signalisiert werden, der Ablauf der Zeitdauer t1 ist jedoch für das Verfahren wesentlich. Die Signalisierung kann in jeder geeigneten Weise geschehen, beispielsweise durch eine Signalisierung über die Leuchteinrichtungen am Fahrzeug oder ein akustisches Signal. Dieses Signal zeigt dem Benutzer an, dass die Zeitdauer t1 verstrichen ist und während dieser Zeitdauer erfolgreich der Bedienwunsch erkannt wurde und auch eine erfolgreiche Überprüfung des ID-Gebers stattgefunden hat. Außerdem ist dies das Signal an den Benutzer, dass zur Bestätigung des Bedienwunsches nun die Entfernung des Körperteils aus dem Erfassungsbereich der Sensoreinrichtung erforderlich ist. Dafür steht dem Benutzer ein begrenzter Zeitraum zur Verfügung. Innerhalb dieser zweiten Zeitdauer t2 überwacht das Fahrzeug die Sensoreinrichtungen und in dem Fall, dass die erste Sensoreinrichtung eine Entfernung des Körperteils erkennt, wird die Auslösung der Fahrzeugfunktion bewirkt.

Wesentlich ist also, dass die Bedienung anhand von zwei Zeitvorgaben erkannt wird, nämlich einmal eine Zeitdauer t1, während der ein Bediener seine Körperteil, beispielsweise einen Fuß, in einem Detektionsbereich belassen muss und einen Zeitbereich t2, innerhalb dessen der Körperteil nach Signalisierung durch das Auto wieder entfernt werden muss.

Diese erfindungsgemäße Verfahrensweise ermöglicht es auch Personen mit körperlichen Einschränkungen oder solchen Personen, die eine bestimmte Bediengeste nicht ausführen können weil diese in deren Kulturkreis als unangemessen gilt, die Bedienung der Fahrzeugfunktion. Geeignete Zeitdauern t1 und t2 liegen im Sekundenbereich, beispielsweise eine Zeitspanne t1 von einigen Sekunden (z.B. zwischen 1 und 5 Sekunden) und eine Zeitdauer t2, die ebenfalls einige Sekunden beträgt (z.B. zwischen 1 und 3 Sekunden), um dem Benutzer ausreichend Zeit zur Reaktion zu geben und andererseits einen klaren Benutzungswillen zu erkennen.

In einer bevorzugten Ausführungsform des Verfahrens werden kapazitive Sensoreinrichtungen verwendet, um wenigstens eine der Sensoreinrichtungen zu bilden. Die kapazitiven Sensoreinrichtungen haben sich insbesondere für die Erfassung von Annäherungen im Außenbereich eines Fahrzeuges bewährt, da sie eine verlässliche Funktion ermöglichen und bei unterschiedlichsten Wetterbedingungen und Umweltbedingungen verlässlich funktionieren. Außerdem liefern kapazitive Sensoreinrichtungen im Gegensatz zu optischen Sensoreinrichtungen einfache auszuwertende Signale in Gestalt von diskreten Ladungs-, Kapazitäts- oder Spannungswerten, die einfachen Auswerteelektroniken zugeführt werden können.

Für aufwendigere Ausführungen ist jedoch auch die Verwendung einer optischen Sensoreinrichtung möglich, beispielsweise auch in Kombination mit einer kapazitiven Sensoreinrichtung. Insbesondere der Bereich hinter dem Fahrzeug kann durch bereits vorhandene optische Sensoreinrichtungen, die einen mehrfachen Zweck erfüllen, zusätzlich erfasst werden, beispielswiese durch Rückfahrkameras, die dann die Funktion der zweiten Sensoreinrichtung übernehmen können.

Besonders bevorzugt ist es, wenn das erfindungsgemäße Verfahren als Öffnungsbedienung einer Heckklappe des Fahrzeuges eingesetzt wird. Grundsätzlich kann das erfindungsgemäße Verfahren für verschiedene Fahrzeugfunktionen eingesetzt werden, beispielsweise auch an Schiebetüren oder motorbetriebenen Schwenktüren. Im Bereich der Heckklappe ist das erfindungsgemäße Verfahren jedoch mit besonderem Vorteil einsetzbar, da das Fahrzeugheck oft als Stauraum für Zuladung dient und diese Zuladung häufig erfolgt, wenn ein Bediener die Hände nicht für eine händische Bedienung der Heckklappe frei hat. Dann kann erfindungsgemäß die Betätigung über eine einfach auszuführende, verlässliche und in ihrer Dynamik gegenüber bekannten Verfahren reduzierte Betätigung mit dem Fuß oder dem Bein ausgeführt werden.

Im vorgenannten Fall ist es sinnvoll, die Erfassungszone der ersten Sensoreinrichtung in einem Bereich unterhalb oder seitlich unterhalb des Fahrzeuges anzuordnen. Die erste Sensoreinrichtung überwacht beispielsweise einen Abschnitt unterhalb des äußeren Umfangs des Fahrzeuges in Bodennähe. Die zweite Sensoreinrichtung weist einen Erfassungsbereich auf, der gegenüber dem Fahrzeug nach hinten versetzt ist, also einer Richtung, die auch der Annäherung durch den Benutzer bei gewünschter Beladung des Heckraumes entspricht.

Vorzugsweise wird außerdem neben der Signalisierung des Ablaufs der Zeitdauer t1, also dem Signal für das Entfernen des Körperteils aus dem Erfassungsbereich, auch eine Signalisierung der bevorstehenden Öffnung des Kofferraums oder der Abdeckung vorgenommen. Dies dient als Warnsignal für den Benutzer, damit er sich ggf. aus dem Schwenkbereich der Fahrzeugklappe entfernen kann.

Schließlich ist es auch im Rahmen der Erfindung möglich, dem Benutzer eine Bedienhilfe in Gestalt einer optischen Signalisierung zu geben, welche den zur Betätigung vorgesehenen Erfassungsbereich der ersten Sensoreinrichtung markiert. Hierzu kann beispielsweise eine LED- oder eine Laserdiode eingesetzt werden, die einen Bodenbereich markiert, der für die Einbringung des Bedienkörperteils und die Detektion vorgesehen ist.

Der Erfindung wird nun anhand der beiliegenden Zeichnung näher erläutert.
Figur 1a zeigt die Heckansicht eines Fahrzeuges zur Ausführung des erfindungsgemäßen Verfahrens;
Figur 1b zeigt eine schematische Seitenansicht des Fahrzeuges aus Figur 1a;
Figur 2 zeigt einen Ablaufplan einer Ausführungsform des erfindungsgemäßen Verfahrens.

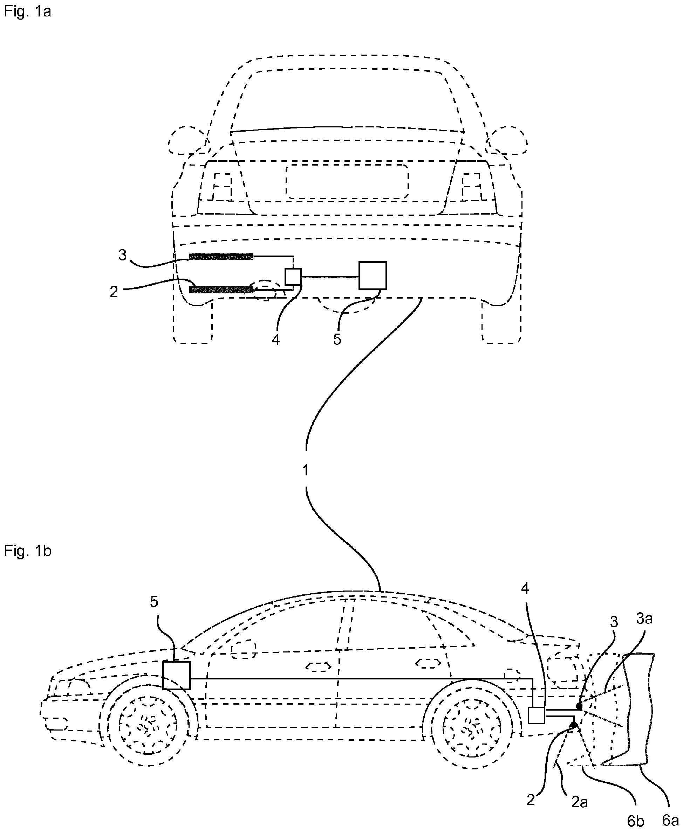

In den Figuren 1a und 1b ist ein Fahrzeug 1 gezeigt, bei dem im Heckbereich Sensorelektroden 2, 3 angeordnet sind. Diese Sensorelektroden sind mit einem Steuergerät verbunden, welches die Sensorelektroden als kapazitive Elektroden ansteuert und die jeweilige Kapazität der Elektrodenanordnung ermittelt. Dieses Steuergerät ist wiederum mit einem zentralen Steuergerät des Fahrzeuges gekoppelt. Das Steuergerät 4 übernimmt die Ansteuerung der Elektroden 2, 3 und die Signalauswertung, also die Ermittlung der Signalantworten und Zuordnung zu einem Bediensignal. Ein eventuell erzeugtes Bediensignal wird von der Steuereinrichtung 4 zu der zentralen Steuereinrichtung 5 übermittelt, welche die Schließfunktion der Heckklappe und die elektrische Öffnung ausführen kann.

Die Elektrode 2 ist als Komponente einer ersten Sensoreinrichtung im unteren Heckbereich angeordnet und ihr Erfassungsbereich 2a ist nach unten gerichtet, wie in Figur 1b zur erkennen ist. Elektrode 3 ist mit dem Erfassungsbereich 3a nach hinten gerichtet. Es ist ersichtlich, dass sich in diesem Beispiel die Erfassungsbereiche 2a und 3a nicht überschneiden.

In Figur 1b ist das Bein eines Benutzers in zwei verschiedenen Positionen gezeigt. In der Position 6a steht der Benutzer hinter dem Heck des Fahrzeuges und das Bein des Benutzers ist ggf. durch die Sensoranordnung 3 mit dem Erfassungsbereich 3a zu erfassen, nicht jedoch durch die Sensoranordnung 2 mit ihrem Erfassungsbereich 2a. Tritt der Benutzer jedoch dicht an die Heckklappe heran und bringt seinen Fuß in den Erfassungsbereich 2a, wie es in der Position 6b gezeigt ist, so ist sowohl eine Erfassung im Bereich 3a also auch eine Erfassung im Bereich 2a möglich. In dieser Position wird anhand des Signals des Sensors 2 erkannt, dass möglicherweise ein Bedienwunsch vorliegt und eine Zeitdauer t1 wird gestartet, während derer der Benutzer in der Position 6b verbleiben muss. Zum Ende der Zeitdauer t1 wird dem Benutzer der Ablauf der Zeitdauer signalisiert, in diesem Beispiel durch ein akustisches Signal, er bewegt sich daraufhin aus der Position 6b zurück in die Position 6a, entfernt sich also aus dem Erfassungsbereich 2a. Geschieht dies innerhalb einer vorgegebenen Zeitdauer t2, gemessen ab dem Signal, so signalisiert die Steuereinrichtung 4 an die Steuereinrichtung 5 einen validen Betätigungsvorgang und die Heckklappe wird geöffnet.

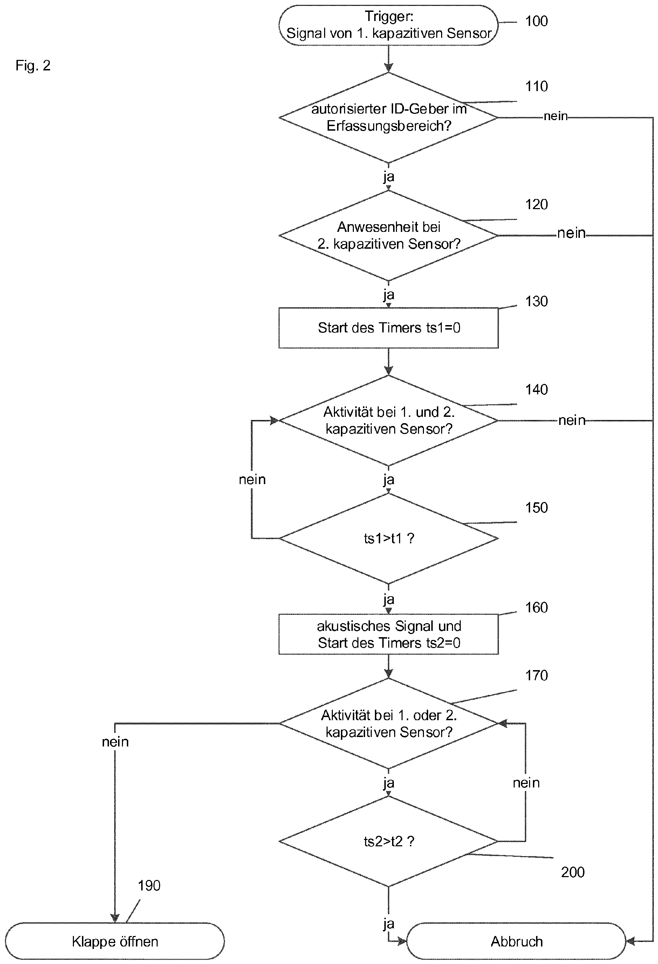

Der Ablauf dieses Verfahrens ist in Figur 2 als Flussdiagramm darstellt. In dieser Ausführungsform wird das Signal des ersten kapazitiven Sensors (des Sensors 2 aus den Figuren 1a und 1b) als Trigger für das Verfahren verwendet. Wird in diesem Erfassungsbereich eine Annäherung detektiert, so wird das Verfahren mit Schritt 100 in Gang gesetzt. Es erfolgt bei 110 die Abfrage des ID-Gebers, welchen der Benutzer mitzuführen hat, um eine schlüssellose Betätigung durchführen zu können. Diese Abfrage erfolgt üblicherweise über Aussendung eines LF-Wecksignals vom Fahrzeug an den ID-Geber, welcher an das Fahrzeug mit einem Kommunikationsablauf im HF-Bereich antwortet. Wird die Autorisierung nicht erfolgreich durchgeführt, beispielsweise weil eine Person ohne berechtigten ID-Geber versucht die Geste auszuführen, wird das Verfahren abgebrochen. Ist eine erfolgreiche Autorisierung erfolgt, wird bei Schritt 120 geprüft, ob der nach hinten gerichtete kapazitive Sensor (Bezugszeichen 3 aus den Figuren 1a und 1b) die Anwesenheit des Benutzers bestätigt. Dies ist erforderlich, da beispielsweise ein Benutzer mit einem an der Leine geführten Hund und mit berechtigtem ID-Geber sich im Heckbereich des Fahrzeuges aufhalten könnte, und der Hund in den Erfassungsbereich des ersten Sensors eintritt. Die Verifizierung der Anwesenheit mit dem zweiten Sensor stellt sicher, dass nur bei Aufenthalt des Benutzers im Betätigungsbereich eine Auslösung erfolgen kann. Bei positiver Bestätigung wird bei Schritt 130 seitens des Fahrzeuges der Timer ts1 auf null gesetzt und gestartet und während der Zeitdauer t1 werden die Aktivitäten der beiden Sensoreinrichtungen überwacht. Aktivität bedeutet in diesem Zusammenhang, dass eine fortgesetzte Detektion von Annäherung oder Anwesenheit durch die Sensoren erfolgen muss. Entfernt der Benutzer sein Bein innerhalb der Zeitdauer t1 aus einem der Erfassungsbereiche des ersten oder des zweiten Sensors, wird fehlende Aktivität bei dem Sensor festgestellt (140) und das Verfahren wird abgebrochen. Ist die Zeitdauer ts1 größer als die vorgegebene Zeitdauer t1 (150) wird ein akustisches Signal ausgegeben und ein zweiter Timer ts2 gestartet (160). Während des Ablaufs der Zeitdauer t2 wird erneut überprüft, ob anhaltende Aktivität bei dem ersten oder dem zweiten kapazitiven Sensor gegeben ist (170). Ist dies nicht der Fall, wird mit Schritt 190 weiterverfahren und ein Steuersignal an die Steuerzentrale des Fahrzeuges gesandt, welche die Heckklappe öffnet. In diesem Fall ist nämlich signalisiert, dass der Benutzer seinen Fuß aus dem Erfassungsbereich entfernt hat. Anderenfalls erfolgt nach Verstreichen der Zeitdauer t2 ein Abbruch des Verfahrens.

## Patentansprüche

1. Verfahren zur Betätigungsabfrage für eine Funktion an einem Kraftfahrzeug mit einer Sensoranordnung, wobei die Sensoranordnung wenigstens zwei beabstandete Sensoreinrichtungen zur Erfassung von jeweiligen Bedienungen durch Annäherungen eines Körperteils eines Benutzers aufweist,
aufweisend die Schritte,
Überwachen der Signale einer ersten Sensoreinrichtung (2) von den Sensoreinrichtungen, bis eine charakteristische erste Signalantwort s1 von der ersten Sensoreinrichtung erfasst wird, die eine Bedienung durch Annäherung an die erste Sensoreinrichtung anzeigt,
Abfragen eines von einem Benutzer mitführbarer ID-Gebers, um eine Autorisierung für den Zugriff auf die angeforderte Funktion zu verifizieren,
Abfragen der Signale einer zweiten Sensoreinrichtung (3) von den Sensoreinrichtungen und Auswerten der zugehörigen Signalantwort s2, zur Ermittlung einer Bedienung durch Annäherung an die zweite Sensoreinrichtung,
wenn die Signalantwort s2 eine Bedienung durch Annäherung an die zweite Sensoreinrichtung anzeigt, Überwachen der Signale der ersten und der zweiten Sensoreinrichtung für eine vorgegebene Zeitdauer t1, wobei die Zeitdauer t1 weniger als fünf Sekunden, bevorzugt weniger als drei Sekunden beträgt,
wenn die Signale während der Zeitdauer t1 eine fortgesetzte Bedienung beider Sensoreinrichtungen anzeigen, Signalisieren des Ablaufs der Zeitdauer t1 an den Benutzer,
Überwachen der Signale der ersten Sensoreinrichtung für eine vorgegebene Zeitdauer t2, wobei die Zeitdauer t2 kleiner als t1 ist,
wenn das Signal der ersten Sensoreinrichtung (2) innerhalb der Zeitdauer t2 eine Aufhebung der Bedienung anzeigt, Auslösen der Funktion des Kraftfahrzeugs.

2. Verfahren nach Anspruch 1, wobei wenigstens eine der Sensoreinrichtungen als kapazitive Sensoreinrichtungen ausgebildet ist.

3. Verfahren nach Anspruch 1 oder 2, wobei wenigstens eine der Sensoreinrichtungen als optische Sensoreinrichtungen ausgebildet ist.

4. Verfahren nach einem der vorangehenden Ansprüche, wobei die auszulösende Funktion eine Öffnung der Heckklappe des Kraftfahrzeuges bewirkt.

5. Verfahren nach Anspruch 4, wobei die Sensoreinrichtungen im Heck des Kraftfahrzeuges angeordnet sind und die erste Sensoreinrichtung einen ersten Erfassungsbereich unterhalb des Fahrzeuges und die zweite Sensoreinrichtung einen zweiten Erfassungsbereich aufweist, der gegenüber dem ersten Erfassungsbereich nach hinten in Fahrzeugrichtung versetzt ist.

6. Verfahren nach einem der vorangehenden Ansprüche, der Ablauf der Zeitdauer t1 optisch oder akustisch signalisiert wird.

7. Verfahren nach einem der vorangehenden Ansprüche, wobei unmittelbar vor dem Auslösen der Funktion des Fahrzeuges ein akustisches oder optisches Signal an den Benutzer gegeben wird.

8. Verfahren nach einem der vorangehenden Ansprüche, wobei ein Erfassungsbereich wenigstens einer Sensoreinrichtung durch eine am Fahrzeug angeordnete Beleuchtungseinrichtung markiert wird.

9. Verfahren nach Anspruch 10, wobei die Beleuchtungseinrichtung aktiviert wird, nachdem die Abfrage des von dem Benutzer mitführbarer ID-Gebers eine Autorisierung ergeben hat.

## Claims

1. A method for querying an actuation for a function in a motor vehicle including a sensor arrangement, wherein the sensor arrangement has at least two spaced sensor devices for detecting respective operations by the approaches of a body part of a user,
comprising the steps of
monitoring the signals of a first sensor device (2) of the sensor devices until a characteristic first signal answer s1 from the first signal device is detected, which indicates an operation caused by approaching the first sensor device,
querying an ID transmitter that can be carried by a user so as to verify an authorization for access to the requested function,
querying the signals of a second sensor device (3) of the sensor devices and evaluating the associated signal answer s2 for determining an operation caused by approaching the second sensor device,
if the signal answer s2 indicates an operation caused by approaching the second sensor device, monitoring the signals of the first and the second sensor devices for a predetermined time period t1, wherein the time period t1 is less than five seconds, preferably less than three seconds,
if the signals during the time period t1 indicate a continued operation of both sensor devices, signaling the expiration of the time period t1 to the user, monitoring the signals of the first signal device for a predetermined time period t2, wherein the time period t2 is shorter than t1,
if the signal of the first sensor device (2) indicates a cancellation of the operation within the time period t2, triggering the function of the motor vehicle.

2. The method according to claim 1, wherein at least one of the sensor devices is formed as a capacitive sensor device.

3. The method according to claim 1 or 2, wherein at least one of the sensor devices is formed as an optical sensor device.

4. The method according to any one of the preceding claims, wherein the function to be triggered results in the opening of the tailgate of the motor vehicle.

5. The method according to claim 4, wherein the sensor devices are arranged at the rear of the motor vehicle and the first sensor device comprises a first detection area below the vehicle and the second sensor device comprises a second detecting portion which is offset from the first detection area towards the rear in vehicle direction.

6. The method according to any one of the preceding claims, wherein the end of the time period t1 is optically or acoustically signaled.

7. The method according to any one of the preceding claims, wherein an acoustic or visual signal is provided to the user immediately before triggering the function of the vehicle.

8. The method according to any one of the preceding claims, wherein a detection range of at least one sensor device is marked by a lighting device arranged on the vehicle.

9. The method according to claim 10, wherein the lighting device is activated after the query of the user-carried ID transmitter has resulted in authorization.

## Revendications

1. Procédé d'interrogation d'actionnement sur un véhicule automobile comportant un dispositif de capteur, dans lequel le dispositif de capteur présent au moins deux capteurs espacés pour détecter des manipulations respectives par l'intermédiaire des rapprochements d'une partie du corps d'un utilisateur, présentant les étapes consistant à :
surveiller les signaux d'un premier dispositif de capteur (2) parmi les dispositifs de capteur, jusqu'à ce qu'une première réponse de signal caractéristique s1 soit détectée par le premier dispositif de capteur, qui affiche une manipulation par l'intermédiaire du rapprochement sur le premier dispositif de capteur,
interroger un émetteur d'identifiant ID pouvant être porté par un utilisateur afin de vérifier une autorisation d'accès à la fonction demandée,
interroger les signaux d'un deuxième dispositif de capteur (3) parmi les dispositifs de capteur et évaluer la réponse de signal correspondant s2, afin de déterminer une manipulation par l'intermédiaire d'un rapprochement sur le deuxième dispositif de capteur,
lorsque la réponse de signal s2 affiche une manipulation par l'intermédiaire d'un rapprochement sur le deuxième dispositif de capteur, surveiller les signaux du premier et du second dispositif de capteur pour une durée temporelle prescrite t1, dans lequel la durée temporelle t1 est inférieure à cinq secondes, de préférence inférieure à trois secondes ;
lorsque les signaux pendant la durée temporelle t1 affichent une manipulation poursuivie des deux dispositifs de capteur, signaliser l'écoulement de la durée temporelle t1 à l'utilisateur,
surveiller les signaux du premier dispositif de capteur pour une durée temporelle prescrite t2, dans lequel la durée temporelle t2 est inférieure à t1,
lorsque le signal du premier dispositif de capteur (2) affiche en l'espace de la durée temporelle t2 une annulation de la manipulation,
déclencher la fonction du véhicule automobile.

2. Procédé selon la revendication 1, dans lequel au moins un des dispositifs de capteur est conçu comme des dispositifs de capteur capacitifs.

3. Procédé selon la revendication 1 ou 2, dans lequel au moins un des dispositifs de capteur est conçu comme des dispositifs de capteur optiques.

4. Procédé selon une des revendications précédentes, dans lequel la fonction déclencheuse provoque une ouverture du hayon du véhicule automobile.

5. Procédé selon la revendication 4, dans lequel les dispositifs de capteurs sont disposés à l'arrière du véhicule automobile et le premier dispositif de capteur présente une première zone de détection au-dessous du véhicule et le deuxième dispositif de capteur présente une deuxième zone de détection, qui est décalée vers l'arrière dans la direction du véhicule par rapport à la première zone de détection.

6. Procédé selon une des revendications précédentes, dans lequel l'écoulement de la durée temporelle t1 est signalisé optiquement ou acoustiquement.

7. Procédé selon une des revendications précédentes, dans lequel directement avant la déclenchement de la fonction du véhicule un signal acoustique ou optique est transmis à l'utilisateur.

8. Procédé selon une des revendications précédentes, dans lequel une zone de détection d'au moins un dispositif de capteur est marquée par un dispositif d'éclairage disposé sur le véhicule.

9. Procédé selon la revendication 10, dans lequel le dispositif d'éclairage est activé, après que l'interrogation de l'émetteur d'ID pouvant être porté par l'utilisateur a émis une autorisation.
